# EUROPEAN PATENT APPLICATION

(11) **EP 4 797 907 A1**
(43) Date of publication of application: **26.08.2026**
(21) Application number: 25177285.1
(22) Date of filing: 19.05.2025
(51) Int. Cl.: H10F 10/165, H10F 77/14, H10F 77/20

(54) **SOLAR CELL, MANUFACTURING METHOD FOR SOLAR CELL, AND PHOTOVOLTAIC MODULE**

(30) Priority: 25.02.2025 CN 202510209071
(71) Applicant: Zhejiang Jinko Solar Co., Ltd., Haining, Zhejiang 314416 (CN)
(72) Inventor: WANG, Lipeng, HAINING, ZHEJIANG 314416 (CN); MAO, Jie, HAINING, ZHEJIANG 314416 (CN); WANG, Zhao, HAINING, ZHEJIANG 314416 (CN); YANG, Jie, HAINING, ZHEJIANG 314416 (CN); ZHENG, Peiting, HAINING, ZHEJIANG 314416 (CN); ZHANG, Xinyu, HAINING, ZHEJIANG 314416 (CN)
(74) Representative: Herrero & Asociados, S.L.

(57) **Abstract**

The present disclosure relates to a solar cell, a manufacturing method for a solar cell, and a photovoltaic module. The solar cell includes: a substrate layer having a first surface and a second surface opposite to each other; a tunneling layer disposed on the first surface; a polysilicon layer disposed on a side of the tunneling layer away from the first surface and having a first region and a second region arranged coplanar, an element doping concentration in the first region being greater than that in the second region, an element doping width in the first region being smaller than that in the second region, and the first region being distributed along a boundary of the second region; and an electrode comprising a first electrode electrically connected to the second region and a second electrode disposed on a side of the second surface.

## Description

### TECHNICAL FIELD

The present disclosure relates to the technical field of solar cells, particularly relates to a solar cell, a manufacturing method for a solar cell, and a photovoltaic module.

### BACKGROUND

With the continuous development of science and technology, solar cells (photovoltaic cells) have been widely applied in people's daily lives due to their characteristics such as environmental benefits, cost-effectiveness, and reliability. Solar cells generate electron-hole pairs through the photoelectric effect, which are then separated to produce an electric current. To enhance the efficiency of solar cells, a passivation contact layer is typically formed within the solar cell, so that the surface state density is reduced by forming the passivation layer on the silicon surface, thereby reducing the recombination of photogenerated carriers at the surface.

Currently, in solar cells, the PN junction is typically formed on a substrate through a boron diffusion process, resulting in a high-concentration boron diffusion layer on a surface of the substrate, which serves as the passivation contact layer. However, due to the relatively high impurity concentration in the boron diffusion layer, a significant amount of recombination tends to occur at the surface of the boron diffusion layer, which deteriorates the passivation performance of the solar cell. Meanwhile, since the surface state of the boron diffusion layer undergoes global passivation, the edge effect is diminished, leading to reduced electric leakage at the edge and an increase in hot spots in the module. Consequently, current solar cells exhibit poor passivation effect.

### SUMMARY

In view of this, to address the above technical issues, there is a need to provide a solar cell, a manufacturing method for a solar cell, and a photovoltaic module, which can enhance the passivation effect of the solar cell while ensuring normal operation of the solar cell.

In a first aspect, the present disclosure provides a solar cell, which includes a substrate layer, a tunneling layer, a polysilicon layer, and an electrode. The substrate layer has a first surface and a second surface opposite to each other. The tunneling layer is disposed on the first surface. The polysilicon layer is disposed on a side of the tunneling layer away from the first surface. The polysilicon layer has a first region and a second region arranged coplanar. An element doping concentration in the first region is greater than an element doping concentration in the second region. An element doping width in the first region is smaller than an element doping width in the second region. The first region is distributed along a boundary of the second region. The electrode includes a first electrode and a second electrode. The first electrode is electrically connected to the second region. The second electrode is disposed on a side of the second surface.

In a second aspect, the present disclosure further provides a manufacturing method for a solar cell, including:
depositing a tunneling oxide layer on a substrate layer, wherein the substrate layer has a first surface and a second surface opposite to each other, and the tunneling oxide layer is deposited on the first surface;
depositing a to-be-annealed layer on a side of the tunnel oxide layer away from the first surface, and subjecting the to-be-annealed layer to an annealing treatment to obtain a preliminary polysilicon layer;
dividing the preliminary polysilicon layer into a first region and a second region arranged coplanar, and doping a doping element into each of the first region and the second region to form a polysilicon layer, wherein an element doping concentration in the first region is greater than an element doping concentration in the second region, and an element doping width in the first region is smaller than an element doping width in the second region; and
providing a first electrode on the second region, forming an electrical connection between the first electrode and the second region, and providing a second electrode on a side of the second surface.

In a third aspect, the present disclosure further provides a photovoltaic module. The photovoltaic module includes a first cover plate, a first adhesive film, a cell string, a second adhesive film, and a second cover plate that are laminated. The cell string includes a plurality of solar cells electrically connected to each other. Each of the solar cells is the solar cell in the first aspect.

In the above-mentioned solar cell, the manufacturing method for the solar cell, and the photovoltaic module, the substrate layer has the first surface and the second surface opposite to each other. The tunneling layer is disposed on the first surface of the substrate layer, serving as a channel for electron tunneling, which facilitates efficient carrier separation and transmission. The first region of the polysilicon layer that is not in contact with the first electrode is subjected to element doping at a higher concentration, and the second region of the polysilicon layer that is in contact with the first electrode is subjected to element doping at a lower concentration, which increases the electric leakage in the first region, thereby lowering the operating temperature of the solar cell and reduce the occurrence of the hot spots. The element doping width in the first region is smaller than the element doping width in the second region of the polysilicon layer, and the first region is distributed along the boundary of the second region, which effectively controls the influence of the region of the polysilicon layer with the higher concentration on the passivation effect of the solar cell, thereby decreasing the surface recombination rate of the polysilicon layer, and enhancing the passivation performance of the solar cell. Meanwhile, the electrical contact formed between the first electrode of the solar cell and the second region of the polysilicon layer can ensure normal flow of current within the cell, and the second electrode disposed on the side of the second surface can ensure normal export of current. Based on above, in the present disclosure, the passivation effect of the solar cell can be enhanced while ensuring the normal operation of the solar cell.

### BRIEF DESCRIPTION OF THE DRAWINGS

FIG. 1 is a schematic structural view of an existing tunnel oxide passivated contact (TOPCon) solar cell;
FIG. 2 is schematic view showing an internal structure of a solar cell according to an embodiment of the present disclosure;
FIG. 3 is a schematic view showing a positional relationship of a first region and a second region according to an embodiment of the present disclosure;
FIG. 4 is a schematic view showing an internal structure of a solar cell provided according to another embodiment of the present disclosure;
FIG. 5 shows ECV curves of boron (B) element in the first region and the second region according to an embodiment of the present disclosure;
FIG. 6 is a schematic view showing Hall mobility and carrier concentration at different positions of a polysilicon layer in different examples of the solar cell according to an embodiment of the present disclosure;
FIG. 7 is a schematic view showing minority carrier lifetime in a first sub-region and a second sub-region according to an embodiment of the present disclosure.

### DETAILED DESCRIPTION

In order to better understand the technical solutions of the present disclosure, the embodiments of the present disclosure will be described in detail with reference to the accompanying drawings.

The terms used in the embodiments of the present disclosure are for the purpose of describing specific embodiments only and are not intended to limit the present disclosure. As used in the embodiments and the appended claims of the present disclosure, the singular forms of "a/an", "said," and "the" are intended to include the plural forms, unless otherwise clearly specified by the context.

It should be understood that the term "and/or" only describes the association relationship of associated objects, indicating that there can be three relationships. For example, A and/or B can indicate three conditions: A alone, both A and B, and B alone. In addition, the character "/" herein generally indicates that the relationship between the former and latter objects is an "or" relationship.

It should be noted that the directional terms such as "above", "below", "left" and "right " described in the embodiments of the present disclosure are described with reference to the angles in the accompanying drawings, and should not be understood to be construed as limitations on the embodiments of the present disclosure. Additionally, in the context, it should be understood that when one element is referred to as being connected "above" or "below" another element. The element not only can be directly connected "above" or "below" another element, but also can be indirectly connected "above" or "below" another element via an intermediate element.

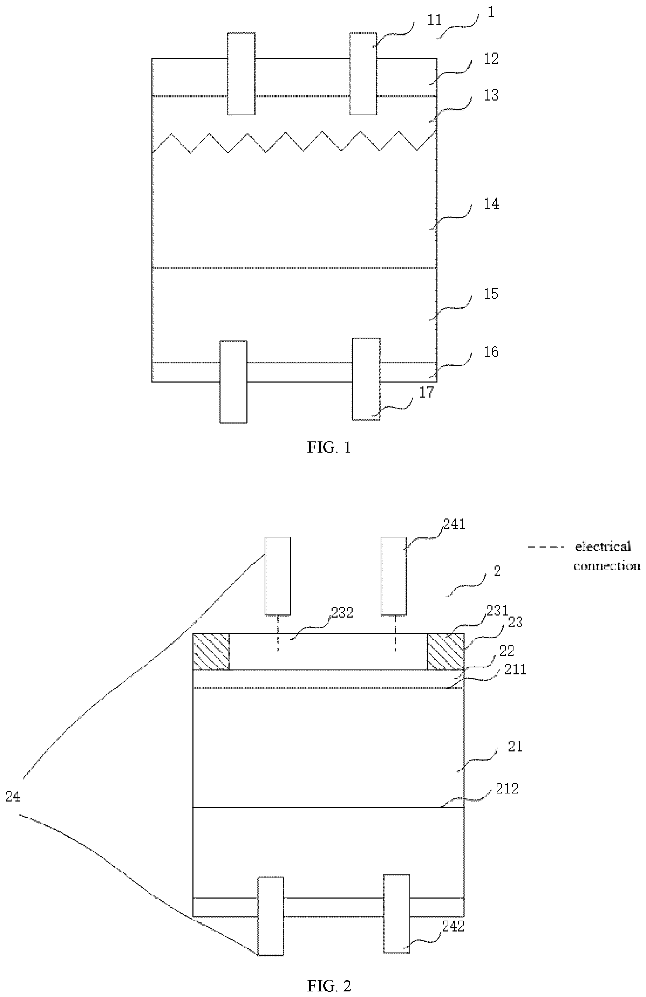

Firstly, it should be understood that in current mainstream solar cells, the PN junction is typically formed on the substrate through a boron diffusion process, resulting in a high-concentration boron diffusion layer on the surface of the substrate. For example, as illustrated in FIG. 1, which shows a schematic structural view of the existing tunnel oxide passivated contact (TOPCon) solar cell, the solar cell 1 includes an upper electrode 11, a front passivation layer 12, a boron-doped polysilicon layer 13, a silicon base 14, an oxide layer 15, a back passivation layer 16, and a lower electrode 17 sequentially disposed from the light-facing side to the back side. The silicon base 14 has a front surface that may be a textured surface and a backside surface that may be a polished surface. The boron-doped polysilicon layer 13 may be of a p+ poly-Si structure. It should be understood that "p+" in the p+ poly-Si structure denotes a p-type semiconductor material with a high doping concentration. The high-concentration doping can enhance the conductivity of the polysilicon layer, enabling more efficient current transmission within the cell. However, due to the relatively high impurity concentration in the boron diffusion layer, a significant amount of recombination tends to occur at the surface of the boron diffusion layer, which deteriorates the passivation performance of the solar cell. Meanwhile, since the surface state of the boron diffusion layer undergoes global passivation (indicated by the absence of the black edge in the photoluminescence (PL) image of the solar cell), the edge effect is diminished, leading to reduced electric leakage at the edge and an increase in hot spots in the module. Consequently, the aforementioned drawbacks are reflected in the poor passivation effect of the current solar cells.

In view of this, the present embodiment provides a solar cell to address the above technical issues.

As illustrated in FIG. 2, which is a schematic partial view of a solar cell 2 provided according to the present embodiment, the solar cell 2 includes a substrate layer 21, a tunneling layer 22, a polysilicon layer 23, and an electrode 24. The substrate layer 21 has a first surface 211 and a second surface 212 opposite to each other. The tunneling layer 22 is disposed on the first surface 211. The polysilicon layer 23 is disposed on a side of the tunneling layer 22 away from the first surface 211. The polysilicon layer 23 has a first region 231 and a second region 232 arranged coplanar. An element doping concentration in the first region 231 is greater than an element doping concentration in the second region 232. An element doping width in the first region 231 is smaller than an element doping width in the second region 232. The first region 231 is distributed along a boundary of the second region 232. The electrode 24 includes a first electrode 241 and a second electrode 242. The first electrode 241 is electrically connected to the second electrode 242. The second electrode 242 is disposed on a side of the second surface 212. For example, in a possible embodiment, the first surface 211 may be a light-facing surface, and the second surface 212 may be a backside surface, in this case, the tunneling layer 22 is disposed on the first surface 211, the polysilicon layer 23 is disposed on a side of the tunneling layer 22 away from the first surface 211, and the second electrode 242 is disposed on a side of the backside surface.

It should be noted that in the present disclosure, the first region 231 and the second region 232 are arranged in a coplanar configuration. This arrangement indicates that the first region 231 and the second region 232 are located in substantially the same plane; however, this plane may not be perfectly flat and may exhibit slight undulations. These undulations can arise from various factors, such as the inherent roughness of the substrate layer 21, which can influence the roughness of the subsequently formed layers on the substrate layer 21. Consequently, while the first region 231 and the second region 232, are designed to be coplanar, the actual surfaces may display minor variations.

It should be noted that the substrate layer 21 may be a silicon base layer. The tunneling layer 22 is disposed on the first surface 211. A material of the tunneling layer 22 may specifically be silicon oxide. Along the thickness direction of the solar cell 2, a thickness of the tunneling layer 22 may be 1 nm to 10 nm. The polysilicon layer 23 is disposed on the side of the tunneling layer 22 away from the first surface 211. Along the thickness direction of the solar cell 2, a thickness of the polysilicon layer 23 may be 50 nm to 500 nm. The thickness direction of the solar cell 2 is perpendicular to each of the first surface 211 and the second surface 212, then the first surface 211 and the second surface 212 of the substrate layer 21 are opposite and parallel to each other. The first electrode 241 is electrically connected to the second region 232. The second electrode 242 is disposed on the side of the second surface 212. The first electrode 241 may be formed on a surface of the polysilicon layer 23 by screen printing, electric plating, or evaporation plating process. The second electrode 242 may be formed on the second surface 212 by screen printing, electric plating, or evaporation plating process. The first electrode 241 or the second electrode 242 may be made of a material selected from one or more of copper, silver, aluminum, or nickel.

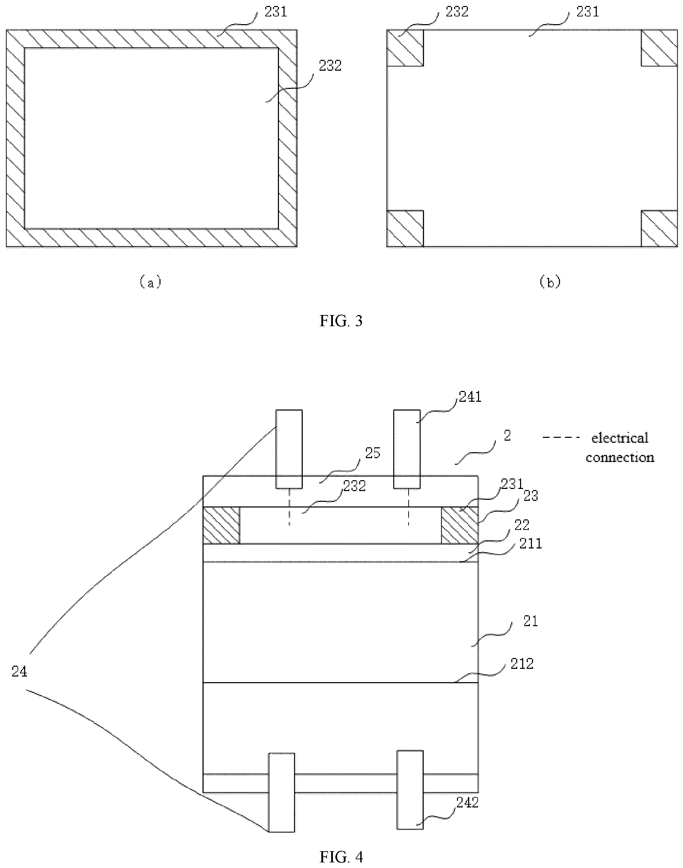

It should be noted that the polysilicon layer 23 has the first region 231 and the second region 232 that are arranged coplanar. An electrical connection is formed between the first electrode 241 and the second region 232. The first region 231 and the second region 232 have conditional restrictions in different dimensions. In terms of the element doping concentration, the element doping concentration in the first region 231 is smaller than the element doping concentration in the second region 232. For example, the element doping concentration in the first region 231 is 1×10¹⁹ atom/cm³, and the element doping concentration in the second region 232 is 1×10¹⁸ atom/cm³. The element that can be doped into the polysilicon layer 23 may specifically be boron (B), phosphorus (P), antimony (Sb), arsenic (As), aluminum (Al), gallium (Ga), or other elements. In terms of the element doping width, the element doping width in the first region 231 is smaller than the element doping width in the second region 232. For example, the element doping width in the first region 231 is 4 nm, and the element doping width in the second region 232 is 8 nm. In terms of the positional relationship, the first region 231 is distributed along the boundary of the second region 232. It should be understood that the second region 232 refers to a region of the polysilicon layer 23 in contact with the first electrode 241, and the first region 231 refers to a region of the polysilicon layer 23 in addition to the second region 232. For example, in a possible embodiment, referring to FIG. 3, which is a schematic view showing the positional relationship between the first region and the second region, assuming that the cross-section of the polysilicon layer 23 on the side of the light-facing surface is a rectangle, the position distribution relationship between the first region and the second region may be depicted as shown in FIG. (a), where the first region is the periphery region of the rectangle, and the second region is the rectangular region contained within it. Alternatively, the position distribution relationship between the first region and the second region may be depicted as shown in FIG. (b), where the first region consists of the four corner regions of the rectangle, and the second region is the region of the rectangle in addition to the four corner regions. The present embodiment simply limits the first region to be distributed along the boundary of the second region, with the first region and the second region collectively forming the entire region of the polysilicon layer, which ensures a continuous region formed by the first region and the second region, without limiting the specific shape of the first region or the second region.

It should be noted that an electrical connection is formed between the first electrode and the second region. Specifically, the electrical connection may be formed between the first electrode and the second region through a direct physical link. For example, the electrical connection is formed between the first electrode and the second region through a physical method such as welding or crimping. Alternatively, the electrical connection may be formed between the first electrode and the second region through an indirect connection via other materials or structures. For example, the electrical connection is formed between the first electrode and the second region through a metallization layer, a conductive adhesive, a conductive film, a conductive oxide, or an embedded structure. By providing two electrodes in the solar cell, the first electrode and the second electrode, the export of current from the solar cell and the connection of the solar cell to the external circuit can be achieved. The first electrode is electrically connected to the second region of the polysilicon layer, serving as either the negative or positive electrode of the solar cell, while the second electrode is disposed on the side of the second surface and can be connected to the substrate layer, the tunneling layer, or other functional layers, serving as either the positive or negative electrode of the solar cell, thereby ensuring the normal flow of current within the solar cell.

In the present embodiment, the polysilicon layer is formed with the first region and the second region that are arranged coplanar. The second region is the region of the polysilicon layer that is in contact with the first electrode. The first region is the region of the polysilicon layer in addition to the second region. The first region is distributed along the boundary of the second region. In the present embodiment, by applying an element doping with a higher concentration to the first region of the polysilicon layer that is not in contact with the first electrode, and applying an element doping with a lower concentration to the second region of the polysilicon layer that is in contact with the first electrode, the electric leakage in the first region is increased, which can decrease the operating temperature of the solar cell and reduce the hot spots. Additionally, by synchronously setting the element doping width in the first region smaller than the element doping width in the second region of the polysilicon layer, the electric leakage conditions in different regions of the polysilicon layer can vary, so that the influence of the region with high doping concentration of the polysilicon layer on the passivation of the solar cell can be effectively controlled, thereby decreasing the surface recombination rate of the polysilicon layer and enhancing the passivation performance of the solar cell. Meanwhile, the electrical contact formed between the first electrode of the solar cell and the second region of the polysilicon layer can ensure normal flow of current within the cell, and the second electrode disposed on the side of the second surface can further ensure normal export of current. Based on this, the present embodiment can enhance the passivation effect of the solar cell while ensuring the normal operation of the solar cell.

In some embodiments, in order to further enhance the passivation effect and stability of the solar cell, a passivation layer may be further deposited in the solar cell. The passivation layer covers a side of the polysilicon layer away from the first surface. Along the thickness direction of the solar cell, a first projection of the first electrode onto the passivation layer is covered by a second projection of the second region onto the passivation layer, with the thickness direction perpendicular to each of the first surface and the second surface. In the present embodiment, by providing the passivation layer, the dangling bonds and the interface state density on the surface of the silicon wafer can be reduced, thereby decreasing the recombination rate. The passivation layer can also serve as the transition layer between the polysilicon layer and the first electrode of the solar cell, which can improve the adhesion and the stability of the first electrode.

It should be noted that a material of the passivation layer may be silicon oxide, silicon nitride, silicon oxynitride, aluminum oxide, titanium oxide, or other materials. The passivation layer may include films of one or more materials and stacked with each other. The thickness of the passivation layer along the thickness direction of the solar cell may be 50 nm to 150 nm. It should be understood that when the first projection of the first electrode onto the passivation layer is covered by the second projection of the second region onto the passivation layer, the first electrode and the second region can make full contact with each other, so that the electron transmission efficiency within the solar cell can be improved by increasing the contact area between the first electrode and the second region. Referring to FIG. 4, which is a schematic partial view of the solar cell 2. As described above, the solar cell 2 includes the substrate layer 21, the tunneling layer 22, the polysilicon layer 23, and the electrode 24. The solar cell further includes a passivation layer 25. As illustrated in FIG. 4, the passivation layer 25 covers the side of the polysilicon layer 23 away from the first surface 211, with the polysilicon layer 23 having the first region 231 and the second region 232 that are arranged coplanar. It should be understood that the horizontal transverse direction is taken as the x direction, the horizontal longitudinal direction is taken as the y direction, and the direction perpendicular to the first surface and the second surface is taken as the z direction, that is, the thickness direction is the z direction, and the thickness of the passivation layer of the solar cell in the thickness direction is the thickness of the passivation layer of the solar cell in the z direction.

In the present embodiment, by covering the side of the polysilicon layer away from the first surface with the passivation layer, the passivation effect and stability of the solar cell can be improved. Meanwhile, by having the first projection of the first electrode onto the passivation layer covered by the second projection of the second region onto the passivation layer, the contact area between the first electrode and the second region can be increased. As a result, in the present embodiment, the passivation effect of the solar cell can be further enhanced while synchronously enhancing the transmission efficiency within the solar cell, that is, synchronously enhancing the conductivity of the solar cell.

In some embodiments, the total doping width of the solar cell is denoted with *l₀*, the element doping width in the first region is denoted with *l₁*, and the element doping width in the second region is denoted with *l₂. l₀, l₁*, and *l₂* satisfy: 0%×*l₀ < l₁*<3%×*l₀*, 97%×*l₀* < *l₂*<100%×*l₀*, and *l₀* = *l₁ + l₂.*

It should be noted that the passivation effect of the solar cell can be further enhanced by testing the relevant parameters of the selected solar cells and controlling the manufactured solar cells to meet the required ranges of the parameters. Taking the solar cell utilizing the p+ poly-Si structure as an example, the corresponding photoluminescence image of the solar cell utilizing the p+ poly-Si structure exhibits a significant characteristic, specifically, the presence of obvious black edge at the peripheral region of the photoluminescence image. The black edge region typically indicates a low radiative recombination efficiency of electrons and holes in that region, which affects the passivation effect of the solar cell. Therefore, by controlling the element doping widths of different regions within the polysilicon layer, the passivation effect of the solar cell can be further enhanced.

It should be noted that the total doping width of the solar cell corresponds to the entire doping region of the polysilicon layer, which may specifically include the first region and the second region. The total doping width, the doping width in the first region, and the doping width in the second region are respectively denoted with *l₀*, *l₁*, and *l₂.* Exemplarily, assuming *l₀* as 20 mm, the doping width *l₁* of the first region may specifically be 1 mm, 2 mm, 3 mm, 4 mm or 5 mm, etc., and the doping width *l₂* of the second region may specifically be 15 mm, 16 mm, 17 mm, 18 mm or 19 mm, etc. It should be understood that when *l₁* is 2 mm, *l₂* is 18 mm; when *l₁* is 3 mm, *l₂* is 17 mm; and when *l₁* is 4 mm, *l₂* is 16 mm; that is, *l₀ = l₁ + l₂.*

By controlling the element doping width in the first region and the element doping width in the second region based on the above conditions, the first region of the solar cell has limited effect on the passivation. Meanwhile, due to the higher element doping concentration in the first region compared to the second region, there is an increase in electric leakage within the first region, which consequently lowers the operating temperature of the solar cell and reduces the formation of hot spots. In a possible embodiment, the first region can be understood as the edge region of the p+ poly-Si structure of the solar cell, while the second region can be understood as the central region of the p+ poly-Si structure of the solar cell.

In the present embodiment, the passivation performance of the solar cell is characterized by introducing the element doping width, and the corresponding relationship between the element doping widths of different regions and the total doping width of the solar cell is controlled, which ensures that the region with the high element doping concentration exerts minimal influence on the passivation of the solar cell, while simultaneously lowering the operating temperature of the solar cell due to increased electric leakage in the region with the high element doping concentration. Consequently, the heat dissipation effect of the solar cell can be enhanced while ensuring the passivation performance of the solar cell, thereby further improving the passivation effect of the solar cell.

In some embodiments, *l₀* is 15mm, and *l₁* and *l₂* satisfy: 0 mm *< l₁* < 5 mm, and 10 mm < *l₂ <* 15 mm. Exemplarily, *l₁* may be 1 mm, 1.05 mm, 1.5 mm, 2 mm, 2.5 mm, 3 mm, 3.24 mm, 3.8 mm, 4 mm, etc. *l₂* may be 11 mm, 11.2 mm, 11.75 mm, 12 mm, 12.5 mm, 13 mm, 13.5 mm, 13.95 mm, 14 mm, etc.

It should be noted that by controlling the solar cell to have the first region and the second region with different element doping widths, the solar cell exhibits different conductive properties. As illustrated in Table 1 below, Comparative Example 1 represents the structure of the mainstream solar cell 1 in the prior art, as depicted in FIG. 1, where the polysilicon layer is subjected to an element doping through a boron diffusion process, with the entire polysilicon layer uniformly doped with boron elements at the same concentration. The structure of the solar cell 1 is as described above, which will not be repeated herein. It should be understood that in Comparative Example 1, due to the uniform doping of boron elements throughout the entire polysilicon layer, the solar cell produced in Comparative Example 1 can be understood as a "black-edge-free cell", meaning that in the photoluminescence image of this solar cell, the edges of its p+ poly-Si structure do not appear black.

Further, Example 1 represents the structure of the solar cell 2, as depicted in FIG. 2, where the first region and the second region of the polysilicon layer are subjected to element doping with different concentrations, with the doping concentration of boron elements in the first region greater than that in the second region, with the boron doping width in the first region smaller than that in the second region, with the boron doping width in the first region controlled between 0 mm and 5 mm, and with the boron doping width in the second region controlled between 10 mm and 15 mm. The structure of the solar cell 2 is as shown in FIG. 2, which will not be repeated herein. It should be understood that due to the doping of boron elements at different concentrations in different regions of the polysilicon layer, and with the boron doping width in the first region controlled between 0 mm and 5 mm, the solar cell produced in Comparative Example 2 can be understood as a "5 mm black-edge cell", meaning that in the photoluminescence image of this solar cell, the black edge of its p+ poly-Si structure measures 5 mm.

Further, Example 2 also represents the structure of the solar cell 2, as depicted in FIG. 2, where the first region and the second region of the polysilicon layer are subjected to element doping with different concentrations, with the doping concentration of boron elements in the first region greater than that in the second region, with the boron doping width in the first region smaller than that in the second region. The difference from Example 1 lies in that Example 2 merely controls the total doping width *l₀* of the solar cell, the element doping width *l₁* in the first region, and the element doping width *l₂* in the second region to satisfy: 0%×*l₀ < l₁*<3%×*l₀*, 97%×*l₀* < *l₂*<100%×*l₀*, and *l₀ = l₁ + l₂*, with the element doping width in the first region being 20 mm, without limiting both the total doping width of the solar cell and the element doping width in the second region. The structure of the solar cell 2 is as shown in FIG. 2, which will not be repeated herein. It should be understood that due to the doping of boron elements at different concentrations in different regions of the polysilicon layer, and with the boron doping width in the first region being 20 mm, the solar cell produced in Example 2 can be understood as a "20 mm black-edge cell", meaning that in the photoluminescence image of this solar cell, the black edge of its p+ poly-Si structure measures 20 mm.

**Table 1**

| Group | Eta (%) | Uoc (V) | Isc (A) | FF (%) | RS (Ω) | Rsh |
|---|---|---|---|---|---|---|
| Comparative Example 1 | 26.139 | 0.7350 | 13.880 | 85.79 | 0.00067 | 3782 |
| Example 1 | 26.159 | 0.7360 | 13.870 | 85.80 | 0.00069 | 1445 |
| Example 2 | 26.889 | 0.7290 | 13.880 | 85.67 | 0.00071 | 971 |

Other parameters of the solar cells in Comparative Example 1 and Examples 1 to 2 are substantially the same and will not be described separately herein. In Table 1, "Eta" indicates the percentage of solar energy converted to electric energy by the cell, "Uoc" indicates the open-circuit voltage, "Isc" indicates the short-circuit current, "FF" indicates the fill factor, "RS" indicates the series resistance, and "Rsh" indicates the parallel resistance.

Based on the testing data for different parameters of the solar cells in Comparative Example 1 and Examples 1 to 2, it can be found that applying element doping to different regions of the polysilicon layer with different element doping concentrations, and controlling the element doping width in the region with the higher element doping concentration to be smaller than that in the region with the lower element doping concentration, results in better electrical property compared to the solar cell that has the entire polysilicon layer uniformly doped with the same element doping concentration. That is, the solar cell 2 manufactured by providing the polysilicon layer with the first region and the second region that are arranged coplanar, with the element doping concentration in the first region being greater than that in the second region, with the element doping width in the first region being smaller than that in the second region, and with the first region being distributed along the boundary of the second region, exhibits better electrical property compared to the mainstream solar cell 1 in the prior art. Additionally, by comparing Example 1 and Example 2, it can be found that in the solar cell 2, further controlling the element doping width in the first region to be between 0 mm and 5 mm, accounting for 0% to 3% of the edge length of the solar cell, results in better electrical property compared to merely controlling the element doping width of the first region to account for 0% to 3% of the total doping width of the solar cell and controlling the element doping concentration in the second region to account for 97% to 100% of the total doping concentration of the solar cell. Therefore, by controlling the total doping width of the solar cell to be 15 mm, controlling the element doping width in the first region to be between 0 mm and 5 mm, and controlling the element doping width in the second region to be between 10 mm and 15 mm, the photoelectric conversion efficiency of the solar cell can be further enhanced while enhancing the passivation effect of the solar cell.

In some embodiments, the element doping concentration in the first region is *n₁*, the element doping concentration in the second region is *n₂*, and *n₁* and *n₂* satisfy: $1 \times {10}^{18} atom / {cm}^{3} \leq {n}_{1} \leq 1 \times {10}^{21} atom / {cm}^{3} ,$ and $1 \times {10}^{17} atom / {cm}^{3} \leq {n}_{2} \leq 1 \times {10}^{20} atom / {cm}^{3} .$

Exemplarily, *n₁* may specifically be 1×10¹⁸ atom/cm³, 1×10¹⁹ atom/cm³, 1×10²⁰ atom/cm³, 1×10²¹ atom/cm³, etc. *n₂* may specifically be 1×10¹⁷ atom/cm³, 1×10¹⁸ atom/cm³, 1×10¹⁹ atom/cm³, 1×10²⁰ atom/cm³, etc. It should be understood that in the solar cell manufactured based on the structure as shown in FIG. 2, the element doping concentration in the first region is greater than the element doping concentration in the second region. For example, assuming the doping element as boron, *n₁* may specifically be 1×10²⁰atom/cm³, and *n₂* may specifically be 1×10¹⁸ atom/cm³, that is, the concentration of boron in the first region is greater than that in the second region. This may arise from the deposition process of the solar cell, which results in a greater accumulation of boron sources in the first region, leading to a higher boron doping concentration in the first region. Consequently, the higher boron content in the first region of the p+ poly-Si of the solar cell causes an increase in the electric leakage in the first region, which can lower the operating temperature of the module and reduce the occurrence of hot spots.

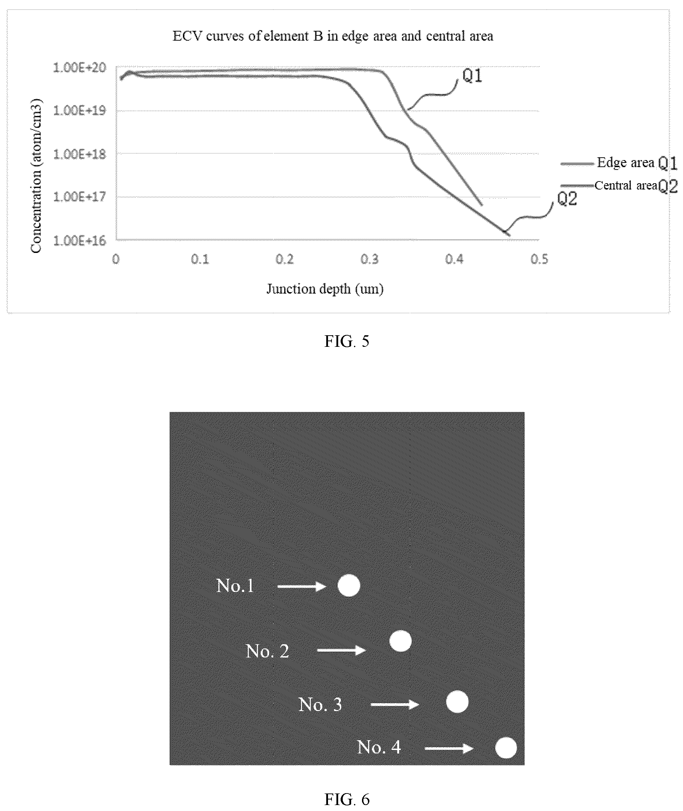

Referring to FIG. 5, FIG. 5 shows ECV curves of boron (B) element in the first region and the second region, with the horizontal axis representing the depth, and with the vertical axis representing the boron doping concentration in the first region and the second region. As can be seen in FIG. 5, in the polysilicon layer, the boron doping concentration in the first region is greater than the boron doping concentration in the second region, and directing from the polysilicon layer toward the tunneling layer, as the depth increases, both of the boron doping concentration in the first region and the boron doping concentration in the second region are gradually decreased. It should be noted that Q1 represents the ECV curve in the first region, and Q2 represents the ECV curve in the second region.

In some embodiments, in the polysilicon layer, the Hall mobility decreases in the direction directing from the center position of the second region toward the first region. The Hall mobility in the first region is indicated with *H₁*, the Hall mobility in the second region is indicated with *H₂*, and *H₁* and *H₂* satisfy: $10 {cm}^{2} / V ⋅ s \leq {H}_{1} \leq 50 {cm}^{2} / V ⋅ s ,$ and $20 {cm}^{2} / V ⋅ s \leq {H}_{2} \leq 100 {cm}^{2} / V ⋅ s .$

It should be noted that, for the characterization of the black edge of the p+poly-Si of the solar cell, in addition to the characterization by the elemental doping widths in the first region and the second region, the Hall mobility can be introduced for the characterization. The Hall mobility is used to describe the mobility rate of the carriers in the semiconductor material under a unit electric field. It should be understood that the Hall mobility decreases in the direction from the center position of the second region toward the first region, that is, the Hall mobility in the first region is smaller than the Hall mobility in the second region. For example, the Hall mobility *H₁* in the first region may specifically be 10 cm²/*V*·*s*, 20 cm²/*V*·*s*, 30 cm²/*V*·*s*, 40 cm²/*V*·*s*, 50 cm²/*V*·*s*, etc. The Hall mobility *H₂* in the second region may specifically be 50 cm²/*V*·*s*, 60 cm²/*V*·*s*, 70 cm²/*V*·*s*, 80 cm²/*V*·*s*, 90 cm²/*V*·*s*, etc. The center position of the second region can be understood as the geometrical center position.

In some embodiments, in the polysilicon layer, the sheet carrier concentration increases in a direction directing from the center position of the second region toward the first region. The sheet carrier concentration in the first region is denoted with *n₃*, the sheet carrier concentration in the second region denoted with *n₄*, and *n₃* and *n₄* satisfy: $1 \times {10}^{17} atom / {cm}^{3} \leq {n}_{3} \leq 1 \times {10}^{21} atom / {cm}^{3} ,$ and $1 \times {10}^{15} atom / {cm}^{3} \leq {n}_{4} \leq 1 \times {10}^{20} atom / {cm}^{3} .$

It should be noted that, for the characterization of the black edge of the p+poly-Si of the solar cell, in addition to the characterization by the elemental doping widths in the first region and the second region, the sheet carrier concentration can be introduced for the characterization. The sheet carrier concentration refers the number of carriers per unit area and unit height, which can determine the electrical property of the solar cell. It should be understood that the sheet carrier concentration increases in the direction directing from the center position of the second region to the first region, that is, the sheet carrier concentration in the first region is greater than the sheet carrier concentration in the second region. For example, the sheet carrier concentration *n₃* in the first region may specifically be 1×10¹⁷ atom/cm³, 1×10¹⁸ atom/cm³, 1×10¹⁹ atom/cm³, 1×10²⁰atom/cm³, 1×10²¹ atom/cm³, etc. The sheet carrier concentration *n₄* in the second region may specifically be 1×10¹⁵ atom/cm³, 1×10¹⁶ atom/cm³, 1×10¹⁷ atom/cm³, 1×10¹⁸ atom/cm³, 1×10¹⁹ atom/cm³, etc. The center position of the second region can be understood as the geometrical center position.

It should be noted that when the element doping widths in the first region and the second region of the polysilicon layer of the solar cell are controlled to be different, both the Hall mobility and the carrier concentration vary at different positions of the polysilicon layer. As shown in Table 2 below, Example 3 represents the Hall mobility and the sheet carrier concentration at the center position of the second region of the solar cell numbered as 1, Example 4 represents the Hall mobility and the sheet carrier concentration at a distance of 30 mm away from the center position of the second region of the solar cell numbered as 2, Example 5 represents the Hall mobility and the sheet carrier concentration at a distance of 60 mm away from the center position of the second region of the solar cell numbered as 3, and Example 6 represents the Hall mobility and the sheet carrier concentration of the first region (edge) of the solar cell numbered as 4.

**Table 2**

| Group | No. | Hall mobility (cm²/*V*·*s*) | Sheet carrier concentration (atom/cm³) |
|---|---|---|---|
| Example 3 | 1 | 35.2 | 2.14E+19 |
| Example 4 | 2 | 34.9 | 2.18E +19 |
| Example 5 | 3 | 34.8 | 2.19E +19 |
| Example 6 | 4 | 30.5 | 2.48E+19 |

Based on the testing data for different parameters of the above Examples 3 to 6, it can be found that by subjecting the different regions of the polysilicon layer to element doping with different element doping concentrations, and by controlling the element doping width in the region with higher doping concentration smaller than that in the region with lower doping concentration, the Hall mobility decreases in the direction from the center position of the second region toward the first region, while the sheet carrier concentration increases in the direction from the center position of the second region toward the first region. Therefore, by controlling the relevant parameters that reflect the characteristics of the black edge of the p+ poly-Si structure of the solar cell within their respective ranges, the passivation effect of the solar cell can be further improved.

Referring to FIG. 6, FIG. 6 is a schematic view showing the Hall mobility and the carrier concentration at different positions of the polysilicon layer in different Examples of the solar cell, wherein No. 1 corresponds to Example 3, No. 2 corresponds to Example 4, No. corresponds to Example 5, and No.4 corresponds to Example 6. It can be seen from the FIG. 6 that the Hall mobility decreases in the direction from the center position of the second region toward the first region, and the sheet carrier concentration increases in the direction from the center position of the second region toward the first region.

In some embodiments, the minority carrier lifetime in the first region is denoted with *τ₁*, the minority carrier lifetime in the second region is denoted with *τ₂*, and *τ₁* and *τ₂* satisfy: 10% ≤ *τ₁*/*τ₂* ≤ 30%.

It should be noted that for the characterization of the black edge of the p+poly-Si of the solar cell, in addition to the characterization by the elemental doping widths in the first region and the second region, the minority carrier lifetime can be introduced for the characterization. The minority carrier lifetimes in different regions of the polysilicon layer are different. The minority carrier lifetime, i.e., the lifetime of minority carriers, refers to the duration from the generation of photogenerated electrons and holes in a semiconductor until their recombination or disappearance. By controlling the minority carrier lifetime *τ₁* in the first region and the minority carrier lifetime *τ₂* in the second region to satisfy 10%≤*τ₁*/*τ₂*≤30%, the overall performance of the solar cell can be further improved.

In some embodiments, the first region includes a first sub-region and a second sub-region. The element doping width in the first sub-region is smaller than the element doping width in the second sub-region. The minority carrier lifetime in the first sub-region at a first light injection dose is denoted with *τ₃*, the minority carrier lifetime in the first sub-region at a second light injection dose is denoted with *τ₄*, and *τ₃* and *τ₄* satisfy: 80%≤*τ₃*/*τ₄*≤120%. The minority carrier lifetime in the second sub-region at the first light injection dose is *τ₅*, the minority carrier lifetime in the second sub-region at the second light injection dose is *τ₆*, and *τ₅* and *τ₆* satisfy: 10%≤*τ₅*/*τ₆*≤30%. The first light injection dose is smaller than the second light injection dose.

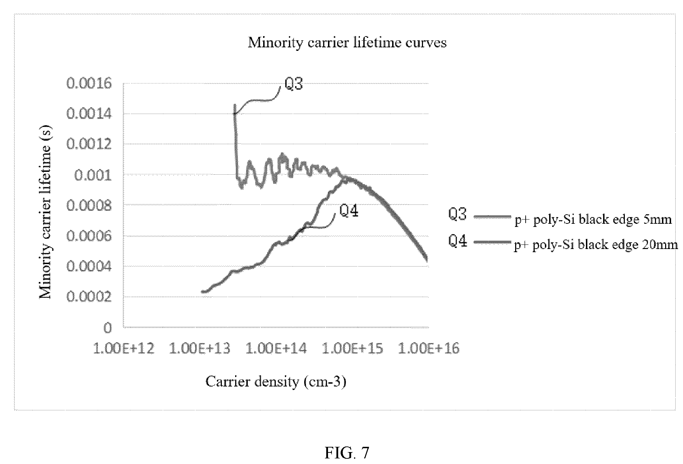

It should be noted that the first region includes the first sub-region and the second sub-region, wherein the first sub-region and the second sub-region represents different types of sub-regions in the first region. Specifically, the first sub-region may be a narrow black-edge region, and the second sub-region may be a wide black-edge region. It should be understood that due to the different elemental doping widths in the first sub-region and the second sub-region, their minority carrier lifetimes vary under different light injection doses. Generally, as the light injection dose increases, the minority carrier lifetime will decrease. However, it has been found that as the black-edge characteristic of the sub-region become more pronounced, the correlation between the minority carrier lifetime of the sub-region and the light injection dose weakens accordingly. Referring to FIG. 7, FIG. 7 is a schematic diagram showing the correlation between the minority carrier lifetimes of the first sub-region and the second sub-region and the light injection dose, with the horizontal axis representing the light injection dose and the vertical axis representing the minority carrier lifetime. Q3 denotes the minority carrier lifetime-light injection dose curve in the first sub-region, and Q4 denotes the minority carrier lifetime-light injection dose curve in the second sub-region. Specifically, the first sub-region may be a region with 5 mm black edge of p+ poly-Si of the solar cell, and the second sub-region may be a region with 20 mm black edge of p+ poly-Si of the solar cell. It can be seen from FIG. 7 that as the light injection dose increases, the minority carrier lifetime in the first sub-region shows an overall decreasing trend, while the minority carrier lifetime in the second sub-region shows a critical value, with an increasing trend before this critical value and a decreasing trend afterward. By controlling the minority carrier lifetime in the first sub-region at the first light injection dose to *τ₃*, and the minority carrier lifetime in the first sub-region at the second light injection dose to *τ₄*, with *τ₃* and *τ₄* satisfying: 80%≤*τ₃*/*τ₄*≤120%, and by controlling the minority carrier lifetime in the second sub-region at the first light injection dose to *τ₅*, and the minority carrier lifetime in the second sub-region at the second light injection dose to *τ₆*, with *τ₅* and *τ₆* satisfying: 10%≤*τ₅*/*τ₆*≤30%, and with the first light injection dose being smaller than the second light inj ection dose, the passivation effect of the solar cell can be further enhanced by controlling the parameter dimension of the minority carrier lifetime.

The present embodiment also provides a manufacturing method for a solar cell, including:
depositing a tunneling oxide layer on a substrate layer, wherein the substrate layer has a first surface and a second surface opposite to each other, and the tunneling oxide layer is deposited on the first surface;
depositing a to-be-annealed layer on a side of the tunnel oxide layer away from the first surface, and subjecting the to-be-annealed layer to an annealing treatment to obtain a preliminary polysilicon layer;
dividing the preliminary polysilicon layer into a first region and a second region arranged coplanar, and doping a doping element into each of the first region and the second region to form a polysilicon layer, wherein an element doping concentration in the first region is greater than an element doping concentration in the second region, and an element doping width in the first region is smaller than an element doping width in the second region; and
providing a first electrode on the second region, forming an electrical connection between the first electrode and the second region, and providing a second electrode on a side of the second surface.

It should be noted that a manufacturing process for the above solar cell 2 may be specifically as follows:

### 1) Deposition of the tunneling oxide layer (SiO₂)

LP (which refers to a specific deposition equipment or technology) machine is used. The deposition temperature is in the range of 400 °C to 900 °C. The thickness of the oxide layer is controlled between 1 nm and 10 nm to achieve an ultrathin tunneling effect.

### 2) Deposition of the polysilicon (poly-Si) layer

The polysilicon layer with a thickness of 50 nm to 500 nm is deposited on the tunneling oxide layer. The deposition temperature is relatively low, between 300 °C and 700 °C, to prevent the thermal damage to the tunneling oxide layer beneath the polysilicon layer.

### 3) Annealing treatment

The deposited polysilicon layer is subjected to annealing and crystallization in an annealing furnace. The annealing temperature is relatively high, between 900 °C and 1400 °C, to promote the crystallization of polysilicon and reduce the defects. The annealing time is typically between 5 min and 100 min, depending on the required crystal quality and process efficiency.

### 4) Boron diffusion

The annealed polysilicon layer is subjected to a boron diffusion treatment. In the boron diffusion, the deposition temperature and the drive-in temperature are in a range of 700 °C to 900 °C and in a range of 800 °C to 1000 °C, respectively. The p+ polysilicon layer is formed through the boron diffusion, with the boron content reaching 1E17-1E21 atom/cm³, to improve the conductivity and form a good ohmic contact.

### 5) Optional formation of the passivation layer on the polysilicon layer

The passivation layer may be further deposited on the polysilicon layer. The passivation layer can reduce surface recombination and improve the passivation of the solar cell.

In the manufacturing method for the solar cell, the substrate layer has the first surface and the second surface opposite to each other. The tunneling layer is disposed on the first surface of the substrate layer, serving as a channel for electron tunneling, which can facilitate efficient carrier separation and transmission. The first region of the polysilicon layer that is not in contact with the first electrode is subjected to element doping with a higher concentration, and the second region of the polysilicon layer that is in contact with the first electrode is subjected to element doping with a lower concentration, which increases the electric leakage in the first region, thereby lowering the operating temperature of the solar cell and reduce the occurrence of the hot spots. The element doping width in the first region is smaller than the element doping width in the second region of the polysilicon layer, and the first region is distributed along the boundary of the second region, which effectively controls the influence of the region of the polysilicon layer with the higher doping concentration on the passivation effect of the solar cell, thereby decreasing the surface recombination rate of the polysilicon layer, and enhancing the passivation performance of the solar cell. Meanwhile, the electrical contact formed between the first electrode of the solar cell and the second region of the polysilicon layer can ensure normal flow of current within the cell, and the second electrode disposed on the side of the second surface can ensure normal export of current. Based on above, in the present disclosure, the passivation effect of the solar cell can be enhanced while ensuring the normal operation of the solar cell.

The present embodiment further provides a photovoltaic module. The photovoltaic module includes a first cover plate, a first adhesive film, a cell string, a second adhesive film, and a second cover plate laminated. The cell string includes a plurality of solar cells that are electrically connected to each other.

It should be noted that the first cover plate is located on the light-facing side of the cell string. The first cover plate is configured to allow sunlight to pass through it. The first cover plate is further configured to improve the waterproof and moisture-proof capabilities of the photovoltaic module. The first cover plate and the second cover plate collectively seal the cell string. During the laminating process of the photovoltaic module, the first adhesive film and the second adhesive film are used to encapsulate the cell string, preventing the cell string from external environmental influences on its performance, while ensuing that the first cover plate, the cell string, and the second cover plate are bonded together as a single unit.

A material of the first adhesive film or the second adhesive film may be one or more of materials such as ethylene-vinyl acetate copolymer (EVA), polyolefin elastomer (POE), polyvinyl butyral (PVB), etc. The material of the first adhesive film or the second adhesive film may also be EPE adhesive film (EVA-POE-EVA co-extruded structure) or EP adhesive film (EVA-EP co-extruded structure).

The present embodiment also provides a stacked cell. The stacked includes a top cell, an intermediate connecting layer, and a bottom cell. The intermediate connecting layer is connected between the bottom cell and the top cell. The top cell is one of a perovskite cell, a cadmium telluride solar cell, a copper indium gallium selenide solar cell, or a gallium arsenide solar cell, and the bottom cell is the above-mentioned solar cell 2.

## Claims

1. A solar cell, comprising:
a substrate layer (21) having a first surface (211) and a second surface (212) opposite to each other;
a tunneling layer (22) disposed on the first surface;
a polysilicon layer (23) disposed on a side of the tunneling layer away from the first surface, the polysilicon layer having a first region (231) and a second region (232) arranged coplanar, an element doping concentration in the first region being greater than an element doping concentration in the second region, an element doping width in the first region being smaller than an element doping width in the second region, and the first region being distributed along a boundary of the second region; and
an electrode (24) comprising a first electrode (241) and a second electrode (242), the first electrode being electrically connected to the second region, and the second electrode being disposed on a side of the second surface.

2. The solar cell according to claim 1, further comprising a passivation layer (25) covering a side of the polysilicon layer away from the first surface, wherein along a thickness direction of the solar cell, a first projection of the first electrode onto the passivation layer is covered by a second projection of the second region onto the passivation layer, and the thickness direction is perpendicular to each of the first surface and the second surface.

3. The solar cell according to claim 1 or 2, wherein a total doping width of the solar cell is *l₀*, the element doping width in the first region is *l₁*, the element doping width in the second region is *l₂*, and *l₀*, *l₁*, and *l₂* satisfy: 0%×*l₀ < l₁*<3%×*l₀*, 97%×*l₀ < l₂*<100%×*l₀*, and *l₀ = l₁ + l₂.*

4. The solar cell according to claim 3, wherein *l₀* is 15 mm, and *l₁* and *l₂* satisfy: 0 mm *< l₁ <* 5 mm, and 10 mm < *l₂<* 15 mm.

5. The solar cell according to any one of claims 1 to 4, wherein the element doping concentration in the first region is *n₁*, the element doping concentration in the second region is *n₂*, and *n₁* and *n₂* satisfy: $1 \times {10}^{18} atom / {cm}^{3} \leq {n}_{1} \leq 1 \times {10}^{21} atom / {cm}^{3} ,$ and $1 \times {10}^{17} atom / {cm}^{3} \leq {n}_{2} \leq 1 \times {10}^{20} atom / {cm}^{3} .$

6. The solar cell according to any one of claims 1 to 5, wherein a Hall mobility in the polysilicon layer decreases in a direction from a center position of the second region toward the first region, a Hall mobility in the first region is *H₁*, a Hall mobility in the second region is *H₂*, and *H₁* and *H₂* satisfy: $10 {cm}^{2} / V ⋅ s \leq {H}_{1} \leq 50 {cm}^{2} / V ⋅ s ,$ and $20 {cm}^{2} / V ⋅ s \leq {H}_{2} \leq 100 {cm}^{2} / V ⋅ s .$

7. The solar cell according to any one of claims 1 to 6, wherein a sheet carrier concentration in the polysilicon layer increases in a direction directing from a center position of the second region toward the first region, a sheet carrier concentration in the first region is *n₃*, a sheet carrier concentration in the second region is *n₄*, and *n₃* and *n₄* satisfy: $1 \times {10}^{17} atom / {cm}^{3} \leq {n}_{3} \leq 1 \times {10}^{21} atom / {cm}^{3} ,$ and $1 \times {10}^{15} atom / {cm}^{3} \leq {n}_{4} \leq 1 \times {10}^{20} atom / {cm}^{3} .$

8. The solar cell according to any one of claims 1 to 7, wherein a minority carrier lifetime in the first region is *τ₁*, a minority carrier lifetime in the second region is *τ₂*, and *τ₁* and *τ₂* satisfy: 10%≤*τ₁*/*τ₂*≤30%.

9. The solar cell according to claim 8, wherein the first region comprises a first sub-region and a second sub-region; an element doping width in the first sub-region is smaller than an element doping width in the second sub-region; a minority carrier lifetime in the first sub-region at a first light injection dose is *τ₃*, a minority carrier lifetime in the first sub-region at a second light injection dose is *τ₄*, and *τ₃* and *τ₄* satisfy: 80%≤*τ₃*/*τ₄*≤120%; a minority carrier lifetime in the second sub-region at the first light injection dose is *τ₅*, a minority carrier lifetime in the second sub-region at the second light injection dose is *τ₆*, and *τ₅* and *τ₆* satisfy: 10%≤*τ₅*/*τ₆*≤30%; and the first light injection dose is smaller than the second light injection dose.

10. The solar cell according to any one of claims 1 to 9, wherein a thickness of the tunneling layer is 1 nm to 10 nm, and a thickness of the polysilicon layer is 50 nm to 500 nm.

11. The solar cell according to any one of claims 2 to 9, wherein a thickness of the passivation layer is 50 nm to 150 nm.

12. The solar cell according to any one of claims 1 to 11, wherein the substrate layer is a silicon base layer, the tunneling layer is made of silicon oxide, the first electrode or the second electrode is made of a material selected from one or more of copper, silver, aluminum, or nickel, and an element doped into the polysilicon layer is selected from boron (B), phosphorus (P), antimony (Sb), arsenic (As), aluminum (Al), or gallium (Ga).

13. The solar cell according to any one of claims 2 to 12, wherein the passivation layer is made of a material selected from silicon oxide, silicon nitride, silicon oxynitride, aluminum oxide, or titanium oxide.

14. A manufacturing method for a solar cell, comprising:
depositing a tunneling oxide layer on a substrate layer, wherein the substrate layer has a first surface and a second surface opposite to each other, and the tunneling oxide layer is deposited on the first surface;
depositing a to-be-annealed layer on a side of the tunnel oxide layer away from the first surface, and subjecting the to-be-annealed layer to an annealing treatment to obtain a preliminary polysilicon layer;
dividing the preliminary polysilicon layer into a first region and a second region arranged coplanar, and doping a doping element into each of the first region and the second region to form a polysilicon layer, wherein an element doping concentration in the first region is greater than an element doping concentration in the second region, and an element doping width in the first region is smaller than an element doping width in the second region; and
providing a first electrode on the second region, forming an electrical connection between the first electrode and the second region, and providing a second electrode on a side of the second surface.

15. A photovoltaic module, comprising a first cover plate, a first adhesive film, a cell string, a second adhesive film, and a second cover plate that are laminated, wherein the cell string comprises a plurality of solar cells electrically connected to each other, and each of the solar cells is the solar cell according to any one of claims 1 to 13.
